# EUROPEAN PATENT APPLICATION

(11) **EP 2 525 385 A1**
(43) Date of publication of application: **21.11.2012**
(21) Application number: 11166206.0
(22) Date of filing: 16.05.2011
(51) Int. Cl.: H01J 37/244, H01J 37/22, H01J 37/28

(54) **Charged-particle microscope**

(71) Applicant: FEI COMPANY, Hillsboro, Oregon 97124-5793 (US)
(72) Inventor: Phifer, Daniel, 5615 PB Eindhoven (NL)
(74) Representative: Bakker, Hendrik

(57) **Abstract**

A method of examining a region of interest of a sample using a charged-particle microscope, comprising the following steps:
- Mounting the sample on a movable sample holder;
- Providing a particle-optical column that can be used to direct at least one beam of particulate radiation onto at least said region, thereby producing an interaction that causes emitted radiation to emanate from the sample;
- In a measurement of a first type, using a first detector to detect a first type of said emitted radiation;
- Using an output of said first detector as a basis to perform at least one of the following actions:
- Assign a value of a measurand to a given coordinate position within said region, for one or more such coordinate positions;
- Construct an image of said region,
wherein the following steps are additionally performed:
- In a measurement of a second type, using a second detector to detect a second type of said emitted radiation;
- Providing computer processing apparatus;
- Using said computer processing apparatus to automatically perform the following actions:
- Based on an output of said second detector, construct a topographical map of at least a portion of the sample proximal to said region of interest;
- Based on said topographical map, identify at least one locus of said sample where sample topography is expected to detrimentally affect accuracy of a measurement of the first type performed at that locus, for at least one geometric attitude of said locus with respect to at least one of said beam and said first detector.

Said computer processing apparatus can be employed to automatically perform at least one of the following actions:
- Draw the attention of a user of said charged-particle microscope to the existence of said locus;
- For said locus, indicate an extent to which said accuracy is expected to be detrimentally affected;
- Calculate at least one modification of said measurement of the first type aimed at improving said accuracy;
- Enact said modification.

## Description

The invention relates to a method of examining a region of interest of a sample using a charged-particle microscope, comprising the following steps:
- Mounting the sample on a movable sample holder;
- Providing a particle-optical column that can be used to direct at least one beam of particulate radiation onto at least said region, thereby producing an interaction that causes emitted radiation to emanate from the sample;
- In a measurement of a first type, using a first detector to detect a first type of said emitted radiation;
- Using an output of said first detector as a basis to perform at least one of the following actions:
   - Assign a value of a measurand to a given coordinate position within said region, for one or more such coordinate positions;
   - Construct an image of said region.

As used throughout this text, the ensuing terms should be interpreted as follows:
- The term "charged particle" refers to an electron or ion (generally a positive ion, such as a Gallium ion or Helium ion, for example).
- The term "microscope" refers to an apparatus that is used to create a magnified image of an object, feature or component that is generally too small to be seen in satisfactory detail with the naked human eye. In addition to having an imaging functionality, such an apparatus may also have a machining functionality; for example, it may be used to locally modify a sample by removing material therefrom ("milling" or "ablation") or adding material thereto ("deposition"). Said imaging functionality and machining functionality may be provided by the same type of charged particle, or may be provided by different types of charged particle; for example, a Focused Ion Beam (FIB) microscope may employ a (focused) ion beam for machining purposes and an electron beam for imaging purposes (a so-called "dual beam" microscope, or "FIB-SEM"), or it may perform machining with a relatively high-energy ion beam and perform imaging with a relatively low-energy ion beam. On the basis of this interpretation, tools such as the following should be regarded as falling within the scope of the current invention: electron microscopes, FIB apparatus, EBlD and IBID apparatus (EBlD = Electron-Beam-Induced Deposition; IBID = lon-Beam-Induced Deposition), etc.
   - The term "particle-optical column" refers to a collection of electrostatic and/or magnetic lenses that can be used to manipulate a charged-particle beam, serving to provide it with a certain focus or deflection, for example, and/or to mitigate one or more aberrations therein.
   - The term detector should be broadly interpreted as encompassing any detection set-up used to register (one or more types of) emitted radiation emanating from a sample. Such a detector may be unitary, or it may be compound in nature and comprise a plurality of sub-detectors, e.g. as in the case of a spatial distribution of detector units about a sample table, or a pixelated detector.
   - The term "region of interest" is intended to refer to any region on or within the sample that can be probed using said beam of particulate radiation, and may encompass the entire sample, or just a part of the sample, or even a single coordinate position. Compared to the cross-sectional area of said beam, said region of interest may be smaller, equal or larger in size. In the event that it is larger in size, it can, for example, be investigated by scanning or stepping said beam across it, by appropriately deflecting the beam and/or moving the sample holder.
   - The term "measurand" refers to any data value that can be assigned by virtue of conducting the measurement of the first type. For example, it might be an intensity value of a particular signal, concentration value of a particular substance, Boolean value indicating whether a particular condition is met or not, etc.

In what follows, the invention will - by way of example - often be set forth in the specific context of electron microscopes. However, such simplification is intended solely for clarity/illustrative purposes, and should not be interpreted as limiting.

Electron microscopy is a well-known technique for imaging microscopic objects.

The basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" beam of ions, allowing supportive activities such as ion-beam milling or ion-beam-induced deposition, for example. In traditional electron microscopes, the imaging beam is "on" for an extended period of time during a given imaging session; however, electron microscopes are also available in which imaging occurs on the basis of a relatively short "flash" or "burst" of electrons, such an approach being of potential benefit when attempting to image moving samples or radiation-sensitive specimens, for example.

When a beam of particulate radiation (such as an electron beam or ion beam) impinges on a sample, it generally interacts with the sample in a manner that causes different types of emitted radiation to emanate from the sample. Such emitted radiation may, for example, comprise Secondary Electrons (SEs), Backscatter Electrons (BEs), visible/infrared/ultraviolet light (fluorescence and cathodoluminescence) and X-rays. Of these radiation types, electrons are relatively easy and cheap to detect, e.g. using a photo-multiplier tube (PMT) in conjunction with a scintillator. The detection of visible/infrared/ultraviolet light is also relatively straightforward, and can be performed using a PMT (without scintillator) or a photodiode cell, for example. On the other hand, X-ray detectors tend to be relatively expensive and slow, and generally offer a relatively limited field of view. Consequently, many present-day electron microscopy applications limit themselves predominantly to the detection of BEs and/or SEs, with possible supplementary detection of visible/infrared/ultraviolet light.

However, there are charged-particle microscopy applications in which the detection and analysis of emitted X-rays from a sample can be very desirable. More specifically, analysis of such X-rays yields information on the X-ray bands of excited atoms/molecules in a sample, thus allowing an elemental/compositional analysis of the sample's constitution. This can be of use in many material investigations in which two or more materials co-exist in a sample. For example, elemental analysis by X-ray techniques can be of great benefit in the field of mineralogy (and the associated fields of geology, mining and petroleum exploration), in which it is desirable to glean information on both the physical structure of a sample (grain size, grain shape, grain orientation, porosity, presence of shock fractures, etc.) and the chemical composition of a sample (elements/isotopes present, and in what molecular configurations they manifest themselves). A problem with the analysis of emitted X-rays in such applications, however, is that the samples involved generally tend to have substantial surface relief/roughness, which can lead to substantial shadowing/obscuration effects when they are imaged using an X-ray detector. One can attempt to mitigate this problem by embedding the sample in a resin block and then performing a polishing operation so as to expose a (somewhat) smoothened face of the sample, but such an approach tends to be cumbersome and time-consuming, and can detrimentally influence the state of the sample in question. Similar problems can also occur for non-mineralogical samples, such as certain biological specimens (e.g. bone or tooth enamel, or shells of crustaceans) and materials-science samples (e.g. metals containing suspected fractures, coatings, composites).

It is an object of the invention to address this issue. More specifically, it is an object of the invention to provide a method of examining a sample using a charged-particle microscope whereby the sample can be more satisfactorily analyzed by detecting X-rays emanating from the sample. In particular, it is an object of the invention that such a method should suffer to a reduced extent from shadowing/obscuration effects associated with surface relief/roughness of the sample.

These and other objects are achieved in a method as specified in the opening paragraph, characterized by the following steps:
- In a measurement of a second type, using a second detector to detect a second type of said emitted radiation;
- Providing computer processing apparatus;
- Using said computer processing apparatus to automatically perform the following actions:
   - Based on an output of said second detector, construct a topographical map of at least a portion of the sample proximal to said region of interest;
   - Based on said topographical map, identify at least one locus of said sample where sample topography is expected to detrimentally affect accuracy of a measurement of the first type performed at that locus, for at least one geometric attitude of said locus with respect to at least one of said beam and said first detector.

In research leading to the invention, the inventor arrived at the insight that, although it might not be of primary usefulness in performing a (compositional/elemental) analysis of a pertinent sample, non-X-ray emitted radiation emanating from such a sample during charged-particle microscopy [observed in said measurement of the second type] could be exploited to provide topographical information about the surface of the sample being investigated, and this information could then be used [by said computer processing apparatus] to predict if certain loci of the sample surface were likely to yield somewhat less accurate/reliable X-ray data/imagery [in said measurement of the first type] due to shadowing/obscuration effects, with due regard to [first-measurement-session] parameters such as the orientation / geometrical attitude of the sample holder with respect to both the incoming charged-particle beam and the employed X-ray detector, and the field of view of said X-ray detector. The operator/user of the charged-particle microscope could then simply note the locations of such locichoosing to ignore data obtained therefrom, or to interpret such data with somewhat more caution, for example - and/or use information on the location of such loci (and, possibly, the magnitude/severity of the shadowing/obscuration effects expected therein) to re-perform X-ray analysis of the sample [i.e. perform a new measurement of the first type] at (automatically proposed) different measurement parameters [generated by said computer processing apparatus], with the aim of mitigating at least some of the predicted shadowing/obscuration effects from at least some of the loci concerned.

Accordingly, in a specific embodiment of a method according to the current invention, said computer processing apparatus automatically performs at least one of the following actions:
(a) Draw the attention of a user of said charged-particle microscope to the existence of said locus/loci;
(b) For said locus/loci, indicate an extent to which said accuracy is expected to be detrimentally affected;
(c) Calculate at least one modification of said measurement of the first type aimed at improving said accuracy;
(d) Enact said modification.

For example:
- In (a), an image or map of (for example) said region of interest could be rendered on a display device - such as an LCD screen, for example - and said locus/loci could be depicted in a given color, or pointed out using an arrow, or denoted using a given symbol or outline shape, for example.
- In (b), a magnitude of the local topography and/or the expected accuracy reduction could be depicted on the display device referred to in (a) using degree/shade of color, assigning a numerical "weight" to a particular locus / set of loci, depicting a (stylized) graph of expected accuracy reduction / cross-section of topography for the locus/loci in question (e.g. in an associated viewing subwindow), etc.
- In (c), said computer processing apparatus could - on the basis of the measurement set-up used during said measurement of the first type - calculate and suggest one or more modifications of said measurement set-up, such as employing a particular tilt and/or rotation of the sample holder [i.e. altering its geometric attitude] with respect to the incoming particle-optical beam and/or employed first detector, for example, with the aim of mitigating (at least some of) the predicted shadowing/obscuration effects.
- In (d), the computer processing apparatus could enact one or more of the modifications referred to in (c) and perform one or more new measurements of the first type with those modifications. Such enaction could be wholly automatic, but could also occur only after obtaining approval/selection from the operator/user of the charged-particle microscope, for example.

In the method according to the current invention, a topographical map is made of "at least a portion of the sample proximal to said region of interest". This syntax should be broadly interpreted as encompassing various possibilities. For example, the "portion" in question may satisfy any of the following criteria:
(i) It may comprise the entire surface of the sample presented to said charged-particle beam;
(ii) It may be smaller than in (i), but encapsulate the entire of said region of interest.
(iii) It may exactly correspond to said region of interest.
(iv) It may partially overlap with said region of interest.
(v) It may not overlap with said region of interest, but be located (substantially) adjacent thereto.

In general, the larger the size of said portion, the greater the accuracy with which shadowing/obscuration effects can be predicted, and the greater the ease/reliability with which corrective modifications of the measurement of the first type can be calculated. However, even when said portion is relatively small, it can still provide useful results. For example, in cases (iv) and (v), a barycenter B_{P} of said portion of which a topographical map is made and a barycenter B_{R} of said region of interest may be disposed along a line L which has a given orientation in a (spherical or polar) coordinate system associated with a reference frame in the microscope. If the detector used in a modeled measurement of the first type has an assumed "line of sight" approximately along L, then topographical information from said portion will allow a usable prediction of possible shadowing/obscuration effects to be expected for such a measurement set-up.

In a particular embodiment of a method according to the current invention, said measurement of the second type is performed prior to said measurement of the first type. In such a scenario, the user/operator of a charged-particle microscope according to the present invention will know *in advance* whether - and to what extent - he can expect to encounter (substantial) shadowing/obscuration effects on a particular sample during the measurement of the first type, and can plan accordingly so as to alleviate such effects or even so as to avoid them completely. However, this is not strictly necessary and, if desired, said measurement of the second type may be performed subsequent to an initial measurement of the first type, or concurrent therewith, or both.

A particular embodiment of the method according to the present invention-already alluded to above - features the following aspects:
- Said first type of emitted radiation comprises X-rays;
- Said second type of emitted radiation comprises electrons.

In a more specific embodiment of this type:
(α) Said first detector is used to perform at least one technique selected from the group comprising Energy Dispersive Spectroscopy (EDS) and Wavelength Dispersive Spectroscopy (WDS);
(β) Said second detector is used to detect at least one category of radiation selected from the group comprising Backscatter Electrons and Secondary Electrons.

In respect of such an embodiment, the following remarks can be made:
- *As regards (α):* EDS and WDS are established techniques for conducting X-ray analysis of the elemental composition of a sample. - In EDS, an incoming high-energy charged particle knocks an inner-shell electron out of an atom in the target, creating an electron hole; an outer-shell electron in the atom then de-excites and fills the hole, releasing its energy surplus as an X-ray photon. The number and energy of X-rays thus emitted is measured using an energy-dispersive spectrometer.
- WDS differs from EDS in that it uses diffraction patterns arising from radiation/matter interaction as its raw data. It generally has a finer spectral resolution that EDS, and is also less sensitive to the effects of artifacts, such as false peaks and amplifier noise; however, a drawback of the technique is that it can analyze only one element at a time, making it generally significantly slower than EDS.

For more information on these techniques, reference is made to the following internet (Wikipedia) sources:
EDS, WDS: bttp://en.wikipedia.org/wiki/Energy-dispersive X-ray spectroscopy WDS: http://en.wikipedia.org/wiki/Wavelength_dispersive_X-ray_spectroscopy
   - *As regards* (*β*): Detectors (such as PMT/scintillator sets, solid state detectors or Multiple-Pixel Photon Counters (MPPCs)) for registering BEs and/or SEs are relatively inexpensive, compact and fast; consequently, several such detectors can often be disposed around the sample holder, allowing (quasi-)spatially resolved detection of electrons emanating from a sample. Typically, the flux of BEs and/or SEs from an irradiated sample is relatively high, giving a good signal-to-noise ratio.

Needless to say, the embodiments just discussed are not limiting of the invention. For example, instead of X-rays, the first type of emitted radiation can comprise another type of radiation that is detected in an orientation-sensitive ("line-of-sight") configuration subject to shadowing/obscuration effects, e.g. infrared/visible/ultraviolet light (as used in "visible" light spectroscopy). Similarly, the second type of emitted radiation may comprise (secondary) ions instead of electrons, for example.

In another embodiment of a method according to the current invention, said measurement of the second type comprises at least one of the following procedures:
(A) Employing multiple detector devices disposed at different positions around said sample holder, so as to allow said topographical map to be constructed using different data sets gathered from different orientations with respect to the sample;
(B) Causing at least one of the relative position and the relative geometrical attitude of said sample holder and said beam to vary in a number of steps, so as to allow said topographical map to be constructed using different data sets gathered during each of said steps.

In respect of such an embodiment, the following remarks can be made:
- *As regards (A):* This approach exploits the fact that, when multiple (sub-)detector devices are disposed at various positions around the sample, electrons emanating therefrom can be detected in a (quasi-)spatially resolved manner, as alluded to above. Put more simply, if, when viewed from an orientation O1 a feature F1 on the sample (at least partially) obscures a feature F2 on the sample, then, when viewed from a different orientation 02, such obscuration will generally not occur (to the same extent). The principle is somewhat analogous to stereo vision, whereby viewing an object through two (or more) spatially separated optical channels gives the sensation of image depth. Approach (A) can be regarded as rendering "2.5D" information - as opposed to full 3D (three-dimensional) information - since information regarding the height/depth of relief on the sample surface (z-information) is *qualitative* rather than quantitative. The technique may also be referred to as rendering "shape from shading".
- *As regards (B):* This approach renders a true 3D perspective of the sample surface, since it yields z-information that is *quantitative.* In this technique, the energy of the charged-particle beam in each step is the same (for example), but said inter-step variation in the relative position and/or relative geometrical attitude of the sample holder and beam allows the beam to reach focus at successively different depth levels within the sample. For this reason, the technique may be referred to as a "deep focus" technique.

One could also envisage a hybrid/combined approach, whereby quantitative height information on (some) coordinate positions from approach (B) is combined with qualitative data from approach (A).

In both situations (A) and (B), there are various mathematical techniques by means of which said data sets can be used to generate said topographical map. For example, by performing addition/subtraction operations on pairs of data sets and comparing results, differences between the sets can be detected, and referenced to averages of the sets. This mathematical approach is well known, and is commonly applied, for example, in the field of astronomy, where photographs of a portion of night sky taken at different times are compared with each other by addition/subtraction to determine if a feature has appeared (*e.g.* a supernova) or moved (*e.g.* an asteroid or comet) with reference to a stagnant background of stars. As an alternative approach, one could, for example, employ the known mathematical technique/algorithm of Photometric Stereo (PS), which is a generalized Shape-From-Shading technique. For more information on this technique, reference is made to the following internet (Wikipedia) source:

### PS: http://en.wikipedia.org/wiki/Photometric_Stereo

As set forth above, once said topographical map is generated, it can be used according to an aspect of the present invention to calculate at least one modification of said measurement of the first type aimed at improving its accuracy, e.g. employing a particular tilt and/or rotation of the sample holder [i.e. altering its geometric attitude] with respect to the incoming particle-optical beam and/or employed first detector. Such a predictive calculation can be performed using well-established mathematical techniques/algorithms such as Ray Tracing (RT)-including its various hybrids, such as Ray Casting (RC) and Beam Tracing (e.g. with a conical beam) - or Hidden Surface Removal (HSR), for example. For more information on these techniques, reference is made to the following internet (Wikipedia) sources:

### RT, RC: http://en.wikipedia.org/wiki/Ray tracing (graphics)

### RC: http://en.wikipedia.org/wiki/Ray_casting

### BT: http.//en.wikipedia.org/wiki/Beam_tracing

### HSR: http.//en.wikipedia.org/wiki/Hidden_surface_removal

One can say that the current invention represents a significant advance in charged-particle microscopy in that, for the first time, it basically allows "error bars" to be assigned to data points gathered during (X-ray or other directional detection) analysis of a relatively rough sample, so that a degree of accuracy / certainty / reliability can be associated with such data points.

The invention will now be elucidated in more detail on the basis of exemplary embodiments and the accompanying schematic drawings, in which:
Figure 1 depicts a flowchart of a particular embodiment of a method according to the current invention.
Figure 2 depicts a flowchart of another embodiment of a method according to the current invention.
Figure 3 renders a plan view (in this case, a front-side plan view) of aspects of a detector suitable for use in conducting a measurement of a second type as set forth in the present invention.
Figure 4 renders a longitudinal cross-sectional view of aspects of a particle-optical microscope (in this case a SEM) with which the method according to the current invention can be implemented.

In the Figures, corresponding parts are indicated using corresponding reference symbols.

### Embodiment 1

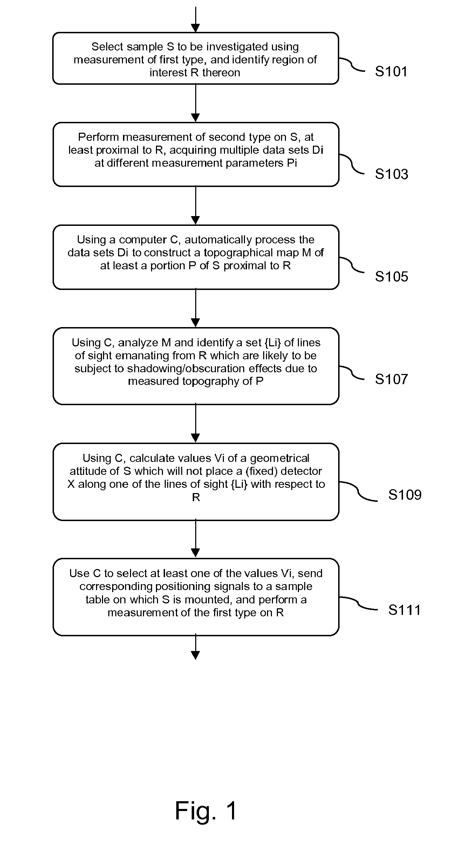

Figure 1 depicts a flowchart of a particular embodiment of a method according to the current invention. For reasons that will become clear in the following discussion, this embodiment can be regarded as involving a "proactive approach", since it seeks *ab initio* to mitigate possible shadowing/obscuration effects *before* they can become an issue. The various steps S101-S111 in this flowchart can be elucidated as follows.
- *S101:* A region R on a sample S is chosen for analysis in a charged-particle microscope (such as a SEM), to be conducted with the aid of a (directional) measurement of a first type, which uses a first detector X to study a first type of emitted radiation emanating from S when it is irradiated with a beam of charged particles (such as electrons). Examples of such a measurement of the first type include EDS or WDS, which study X-rays emitted from S.
- *S103:* The sample S (e.g. a mineralogical specimen) has a relatively rough exposed surface, and it is suspected that, during said measurement of the first type, measurement accuracy/reliability may be locally compromised by shadowing/obscuration effects caused by this roughness. Consequently, it is decided to first submit the sample S to a measurement of a second type, which is conducted in the same particle-optical microscope, but which studies a second type of emitted radiation emanating from S - for example, SEs or BEs. This measurement of the second type involves the acquisition of multiple data sets Di, obtained at different measurement parameters Pi. Examples of such different measurement parameters Pi include:
   - Different detection angles. For example, one might use a so-called "quadrant mode" set-up, whereby four different electron detectors (e.g. solid state detectors) are disposed at different angular positions around S. Such a set-up can yield four different data sets Di, each one corresponding to a specific one of said angular positions (Pi).
   - Different z-heights of the sample S with respect to the incoming beam of particulate radiation. For example, one might choose to step S through five different height increments (Pi) - by adjusting the z-position of the sample table on which S is mounted - and acquire a data set Di at each of these positions.
- *S105:* Computer processing apparatus C is used to perform data-processing operations on the data sets Di resulting from the previous step, distilling therefrom a topographical map M of at least a portion P of the sample S proximal to said region of interest R. Such an operation might, for example, involve invoking C to perform calculations of the type (Dj-Dk)/(Dj+Dk) for given pairs (j,k) of data sets Di, so as to determine differences between the sets as a function of the associated parameter Pi, such differences being attributed to sample topography.
- *S107:* In this step, the processing apparatus C automatically analyzes M, so as to identify loci of S where sample topography is expected to detrimentally affect accuracy of said measurement of the first type when it is performed at such loci, for at least one geometric attitude of each such locus with respect to at least one of said beam and said first detector X. In this particular case, C identifies a set {Li} of lines of sight Li emanating from R which are likely to be subject to the above-mentioned shadowing/obscuration effects. The elements of {Li} represent lines of sight Li which, if employed, are expected to yield reduced measurement accuracy/reliability during said measurement of the first type.
- *S109:* Here, processing apparatus C is used to calculate geometric attitudes Vi (e.g. combined height, rotation and tilt values) of S with respect to X which will not place the line segment [RX] along one of the lines of sight {Li} found in the previous step ("prevention is better than cure" approach), or- in a case whereby such lines of sight cannot be entirely avoided - which will place [RX] on a line of sight Li that suffers relatively lightly from shadowing/obscuration effects ("best of a bad lot" approach).
- *S111:* In this step, at least one selected geometric attitude Vi resulting from the previous step is converted by C into appropriate stage positioning signals for the sample table on which S is mounted, and a measurement of the first type is then performed on R.

### Embodiment 2

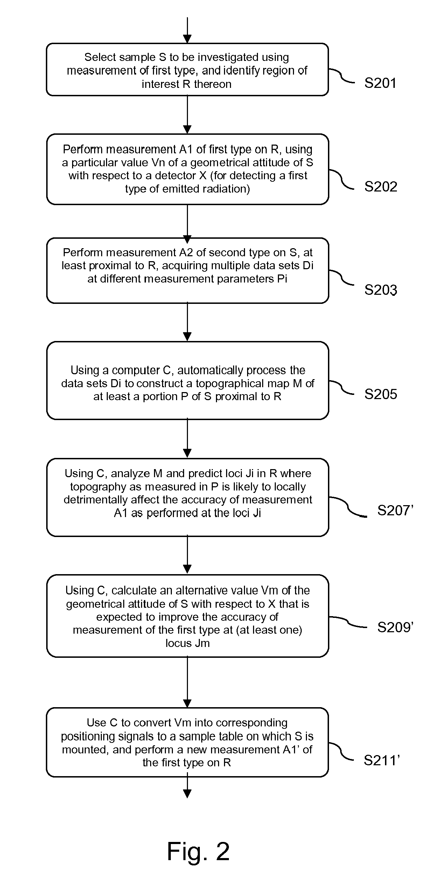

Figure 2 depicts a flowchart of a different embodiment of a method according to the current invention. For reasons that will become clear in the following discussion, this embodiment can be regarded as involving a "reactive approach", since it seeks *retrospectively* to draw attention to possible shadowing/obscuration effects *after they* may have crept into a measurement. The various steps S201-S211' in this flowchart will be elucidated in what follows. In many cases, there will be a certain similarity to corresponding steps of Figure 1, in which case the attendant elucidation may be abbreviated.
- *S201:* As in Figure 1, in this step, a region R on a sample S is chosen for analysis in a charged-particle microscope (e.g. SEM or FIB-SEM), to be conducted with the aid of a (directional) measurement A1 of a first type (e.g. EDS or WDS), which uses a first detector X to study a first type of emitted radiation (e.g. X-rays) emanating from S when it is irradiated with a beam of charged particles (e.g. electrons).
- *S202:* In this step, said measurement A1 of the first type is conducted on R. During this measurement A1, the geometrical attitude (e.g. combined height, rotation and tilt values) of S with respect to X has a particular value Vn.
- *S203:* Here, S is subjected to a measurement A2 of the second type, which studies a second type of emitted radiation emanating from S - for example, SEs or BEs. This measurement A2 once again involves the acquisition of multiple data sets Di, obtained at different measurement parameters Pi. Refer, for example, to the examples given in Embodiment 1 with regard to step S103.
- *S205:* Once again, computer processing apparatus C is used to perform data-processing operations on the data sets Di resulting from the previous step, distilling therefrom a topographical map M of at least a portion P of the sample S proximal to said region of interest R.
- *S207':* In this step, the processing apparatus C automatically analyzes M, so as to identify loci Ji of S where sample topography is expected to detrimentally affect accuracy of said measurement A1 of the first type when it is performed at such loci Ji, for at least one geometric attitude of each such locus with respect to at least one of said beam and said first detector X.
- *S209':* Here, processing apparatus C is used to calculate a geometric attitude Vm (of S with respect to X) that is different to Vn and that is expected to improve the accuracy of measurement A1 when performed at at least one locus Jm identified in the previous step.
- *S111':* In this step, Vm is converted by C into appropriate stage positioning signals for the sample table on which S is mounted, and a new measurement A1' of the first type is then performed on R.

### Embodiment 3

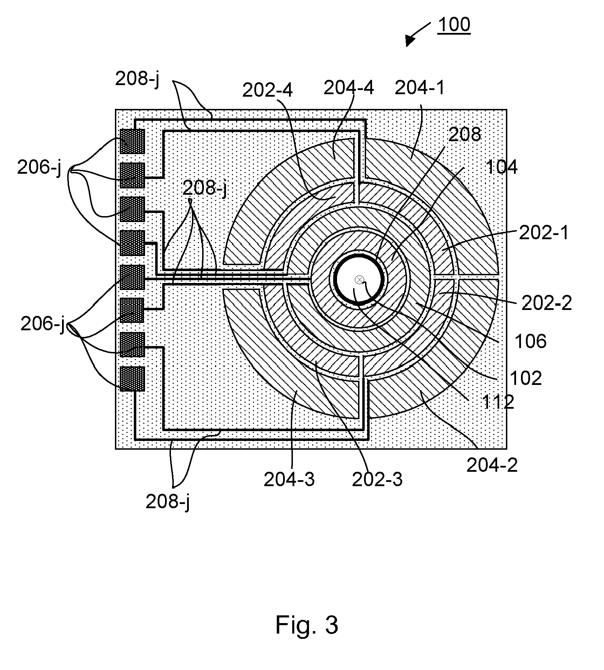

Figure 3 renders a schematic plan view (in this case, a front-side plan view) of aspects of a detector 100 suitable for use in conducting a measurement of a second type as pertaining to the present invention. In this particular case, the depicted detector 100 is suitable for measuring electrons (both SEs and BEs) in a so-called quadrant configuration.

As here depicted, detector 100 is provided with a through-hole 112 which is centred about an axis 102 perpendicular to the drawing. In use, this axis 102 will generally coincide with the optical axis of the charged-particle microscope in which the detector 100 is mounted. When used in a SEM, there may be no need for such a central hole 112; on the contrary, the presence of such a hole might only cause an area of the detector to be 'blind' to electrons emanating from a sample under investigation. However, in a TEM, there is often a need to detect electrons that are deflected/scattered through an angle larger than a predefined threshold value, but to allow electrons scattered through a smaller angle to pass through the through-hole 112 and be imaged by imaging optics of the TEM.

The detector 100 comprises annular detector areas 104 and 106, in nested arrangement. In addition, four detector areas 202-i (i = 1...4) are arranged in annular configuration around the annular detector area 106, and four detector areas 204-i are similarly disposed around detector areas 202-i. The detector 100 further comprises a number of connection pads 206-j, which allow detection of a signal from each detector area (j = 0... N, N being the total number of detector areas on the detector 100, with one of the pads being connected to a common electrode formed on the backside of the detector 100). Each connection pad 206-j is connected to its corresponding detector area via a conductive track 208-j.

Structural details of such a detector 100 can be gleaned, for example, from co-pending European patent application EP 11150672. However, a brief description of the detector's structure will be given here.

The detector 100 is disposed on an n-type substrate (e.g. an n-doped silicon substrate with a typical volume resistivity of 1-10 Ω·cm), which is metallized on one side so as to form said common backside electrode. On the front side of this substrate (depicted in Figure 3), an intrinsic layer (active layer) in the form of an epitaxial Si layer is formed (e.g. with a thickness of 40 µm). On top of this epitaxial layer, a boron layer is deposited, whereby a p⁺ -type diffusion layer of silicon-boride layer is created. Enclosing the various radiation-sensitive detector areas 104, 106, 202-i, 204-i, p-doped (e.g. boron-doped) boundaries are formed. Said detector areas are electrically insulated from each other by an interposed n-doped implant area (e.g. with a phosphorus dopant) that, together with said p-doped areas, forms a p-n-p barrier between said detector areas. Part of said epitaxial layer is covered by a layer of silicon dioxide, upon which aluminium tracks are formed for the purpose of transporting the signals from said detector areas (ultimately connecting to tracks 208-j in Figure 3). A signal from each detector area 104, 106, 202-i, 204-i can be registered by measuring the current/voltage induced between said common backside electrode and the specific aluminium track of the detector area in question.

Each detector area thus constitutes a so-called "P-I-N diode", formed by said p⁺-diffusion layer, intrinsic layer, and n-doped substrate. Any holes in the intrinsic layer will travel to the p⁺-layer, and any electrons in the intrinsic layer will travel to the n-doped substrate. Electron/hole pairs generated in the intrinsic layer will thus induce a current. Such electron/hole pairs are, for example, generated in a sample by impinging electrons (from an incoming electron beam), whereby the number of generated electron/hole pairs will be proportional to the energy with which the electrons enter the intrinsic layer and inversely proportional to the energy needed to form an electron/hole pair.

In operation, a beam of electrons is directed along the axis 102 from the backside of the detector through the through-hole 112 onto a sample situated at the front (radiation-sensitive) side of the detector 100. At the sample, SEs and BEs will be liberated by the impinging electron beam. SEs are often categorized as electrons that emerge from the sample with an energy less than 50 eV, while BEs are generally categorized as electrons emerging from the sample with an energy in excess of 50 eV. Preferably, the detector 100 is maintained at a slight positive potential with respect to said sample, by electrically biasing the sample or the detector; in this way, SEs will be accelerated towards the detector. In general, SEs will be detected quite close to the axis 102, as they have relatively little energy radial to the axis, whereas BEs will be detected by the detector areas further removed from the axis 102, as BEs often have more significant radial energy to start off with.

As set forth above, the detector areas more distal from the axis 102 are segmented into four 90° segments. By comparing the signals induced in different such segments (and also by comparing the signal from different annuli), one can effectively spatially resolve the electrons emanating from the sample. By applying an appropriate algorithm to these various signals, one can deduce topographical information on the sample under investigation.

### Embodiment 4

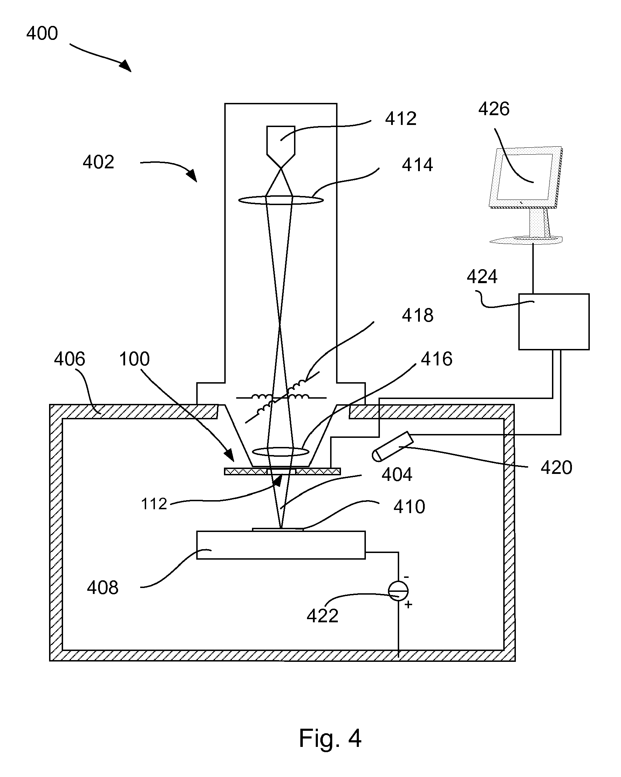

Figure 4 shows a charged-particle microscope 400, which, in this case, is a SEM. The microscope 400 comprises a particle-optical column 402, which produces a charged-particle beam 404 (in this case, an electron beam). The particle-optical column 402 is mounted on a vacuum chamber 406, which comprising a sample holder / stage 408 for holding a sample 410. The vacuum chamber 406 is evacuated using vacuum pumps (not depicted). The sample holder 408, or at least the sample 410, may be biased (floated) to an electrical potential with respect to ground with the aid of voltage source 422.

The particle-optical column 402 comprises an electron source 412, lenses 414, 416 to focus the electron beam 404 onto the sample 410, and a deflection unit 418. The apparatus is further equipped with a first detector 420, for detecting a first type of emitted radiation emanating from the sample 410 in response to irradiation by the beam 404; in the present example, the detector 420 is an X-ray detector (such as an EDS or WDS detector) for detecting X-rays. Also depicted is a second detector 100, for detecting a second type of emitted radiation emanating from the sample 410 in response to irradiation by the beam 404; in the present example, the detector 100 is a segmented electron detector as set forth in Embodiment 3 above. The apparatus further comprises a computer processing apparatus (controller) 424 for controlling *inter alia* the deflection unit 418, lenses 414, and detectors 420,100, and displaying information gathered from the detectors 420,100 on a display unit 426.

By scanning the beam 404 over the sample 410, emitted radiation-comprising, for example, X-rays, secondary electrons (SEs) and backscattered electrons (BEs) - emanates from the sample 410. X-rays are detected by first detector 420, whereas SEs/BEs are detected by second detector 100. As the emitted radiation is position-sensitive (due to said scanning motion), the information obtained from the detectors 420, 100, will also be position-dependent.

The signals from the detectors 420,100 are processed by the processing apparatus 424, and displayed on display unit 426. Such processing may include combining, integrating, subtracting, false colouring, edge enhancing, and other processing known to the person skilled in the art. In addition, automated recognition processes, e.g. as used for particle analysis, may be included in such processing. In the context of the current invention, the processing apparatus 424 will *(inter alia):*
- Construct a topographical map M of (at least a portion of) the sample 410, based on the output of second detector 100.
- Use M to identify loci of the sample 410 where sample topography is expected to detrimentally affect accuracy of measurement results obtained from those loci using first detector 420, for at least a set of geometric attitudes of said loci with respect to at least one of the beam 404 and the first detector 420.

It should be noted that many refinements and alternatives of such a set-up will be known to the skilled artisan, including, but not limited to, the detection of (infrared/visible/ultraviolet) light emanating from the sample 410, the use of dual beams (for example an electron beam 404 for imaging and an ion beam for machining (or, in some cases, imaging the sample 410), the use of a controlled environment at the sample 410 (for example, maintaining a pressure of several mbar - as used in a so-called Environmental SEM - or by admitting gasses, such as etching or precursor gasses), etc.

## Claims

1. A method of examining a region of interest of a sample using a charged-particle microscope, comprising the following steps:
- Mounting the sample on a movable sample holder;
- Providing a particle-optical column that can be used to direct at least one beam of particulate radiation onto at least said region, thereby producing an interaction that causes emitted radiation to emanate from the sample;
- In a measurement of a first type, using a first detector to detect a first type of said emitted radiation;
- Using an output of said first detector as a basis to perform at least one of the following actions:
- Assign a value of a measurand to a given coordinate position within said region, for one or more such coordinate positions;
- Construct an image of said region,
**characterized by** the following steps:
- In a measurement of a second type, using a second detector to detect a second type of said emitted radiation;
- Providing computer processing apparatus;
- Using said computer processing apparatus to automatically perform the following actions:
- Based on an output of said second detector, construct a topographical map of at least a portion of the sample proximal to said region of interest;
- Based on said topographical map, identify at least one locus of said sample where sample topography is expected to detrimentally affect accuracy of a measurement of the first type performed at that locus, for at least one geometric attitude of said locus with respect to at least one of said beam and said first detector.

2. A method as claimed in claim 1, wherein said computer processing apparatus automatically performs at least one of the following actions:
- Draw the attention of a user of said charged-particle microscope to the existence of said locus;
- For said locus, indicate an extent to which said accuracy is expected to be detrimentally affected;
- Calculate at least one modification of said measurement of the first type aimed at improving said accuracy;
- Enact said modification.

3. A method as claimed in claim 2, wherein said modification comprises altering a geometric attitude of said sample holder with respect to at least one of said beam and said first detector.

4. A method as claimed in any preceding claim, wherein said measurement of the second type is performed prior to said measurement of the first type.

5. A method as claimed in any preceding claim, wherein:
- Said first type of emitted radiation comprises X-rays;
- Said second type of emitted radiation comprises electrons.

6. A method as claimed in claim 5, wherein:
- Said first detector is used to perform at least one technique selected from the group comprising Energy Dispersive Spectroscopy and Wavelength Dispersive Spectroscopy;
- Said second detector is used to detect at least one category of radiation selected from the group comprising Backscatter Electrons and Secondary Electrons.

7. A method as claimed in claim 5 or 6, wherein said measurement of the second type comprises at least one of the following procedures:
- Employing multiple detector devices disposed at different positions around said sample holder, so as to allow said topographical map to be constructed using different data sets gathered from different orientations with respect to the sample;
- Causing at least one of the relative position and the relative geometrical attitude of said sample holder and said beam to vary in a number of steps, so as to allow said topographical map to be constructed using different data sets gathered during each of said steps.

8. A charged-particle microscope constructed and arranged to perform a method as claimed in any of claims 1-7.

9. A charged-particle microscope as claimed in claim 8, comprising at least one of a Scanning Electron Microscope column and a Focused Ion Beam column.
